# EUROPEAN PATENT APPLICATION

(11) **EP 4 225 000 A1**
(43) Date of publication of application: **09.08.2023**
(21) Application number: 22155199.7
(22) Date of filing: 04.02.2022
(51) Int. Cl.: H05K 1/18, B60R 16/02

(54) **FLEXIBLE ELECTRICAL BUS BAR AND METHOD OF MANUFACTURING THE SAME**

(71) Applicant: Aptiv Technologies Limited, St. Michael (BB)
(72) Inventor: DURSE, Nicholas A., Youngstown, 44511 (US); MARZO, Steven W., Cortland, 44410 (US); WEIDNER, Jonathan D., Conneautville, 16406 (US); PETERSON, David R., Aurora, 44202 (US)
(74) Representative: Westphal, Mussgnug & Partner, Patentanwälte mbB

(57) **Abstract**

An electrical bus bar assembly (110) includes an elongate flexible electrical conductor (112) formed of a strip of electrically conductive material having a generally rectangular cross section and a width to thickness ratio of at least 20:1 and a dielectric material (116) covering a central portion (114) of the electrical conductor (112) such that the electrical conductor (112) has exposed distal portions (118) at each end of the assembly (110). A method (100) for forming such as assembly (110) includes the steps of forming (102) a flexible strip (112) from an electrically conductive sheet such that the strip (112) has a generally rectangular cross section with a width to thickness ratio of at least 20:1 and covering (104) a central portion (114) of the strip (112) with a dielectric material (116) and leaving distal portions (118) at each end exposed

## Description

This application is directed to an electrical bus bar, particularly a flexible bus bar that is configured to be used in high voltage circuit applications, such as electric or hybrid electric vehicles.

According to one or more aspects of the present disclosure, an electrical bus bar assembly includes an elongate flexible electrical conductor formed of a strip of electrically conductive material having a generally rectangular cross section and a width to thickness ratio of at least 20:1 and a dielectric material covering a central portion of the electrical conductor such that the electrical conductor has exposed distal portions at each end of the assembly.

In one or more embodiments of the electronic assembly according to the previous paragraph, the electrical bus bar assembly, one of the exposed portions is folded back onto itself to form an integral blade-type male terminal.

In one or more embodiments of the electrical bus bar assembly according to any one of the previous paragraphs, the male terminal is formed of at least two layers of the electrically conductive material.

In one or more embodiments of the electrical bus bar assembly according to any one of the previous paragraphs, a leading edge of a free end of the male terminal has a rounded edge.

In one or more embodiments of the electrical bus bar assembly according to any one of the previous paragraphs, a width of the male terminal is less than a width of the electrical conductor covered by the dielectric material.

In one or more embodiments of the electrical bus bar assembly according to any one of the previous paragraphs, a thickness of the male terminal is greater than a thickness of the central portion of the electrical conductor.

In one or more embodiments of the electrical bus bar assembly according to any one of the previous paragraphs, the flexible electrical conductor may be bent by a force of less than 5 newtons.

In one or more embodiments of the electrical bus bar assembly according to any one of the previous paragraphs, the male terminal extends beyond the width of the central portion of the electrical conductor.

In one or more embodiments of the electrical bus bar assembly according to any one of the previous paragraphs, the thickness of the electrical conductor is in a range of 0.1 millimeters to 0.5 millimeters.

In one or more embodiments of the electrical bus bar assembly according to any one of the previous paragraphs, one of the exposed distal portions defines two parallel tabs extending from the bus bar and wherein the two tabs are configured to be welded to two different parallel sides of an electrical terminal.

According to one or more aspects of the present disclosure, a method of manufacturing an electrical bus bar assembly includes the steps of forming a flexible strip from an electrically conductive sheet such that the strip has a generally rectangular cross section with a width to thickness ratio of at least 20:1 and covering a central portion of the strip with a dielectric material and leaving distal portions at each end exposed.

In one or more embodiments of the method according to the previous paragraph, the method further comprises the step of folding a distal portion back onto itself, thereby forming an integral blade-type male terminal.

In one or more embodiments of the method according to any one of the previous paragraphs, the male terminal is formed of at least two layers of the strip.

In one or more embodiments of the method according to any one of the previous paragraphs, the distal portion is folded such that a leading edge of a free end of the male terminal defines a rounded edge.

In one or more embodiments of the method according to any one of the previous paragraphs, a width of the male terminal is less than a width of the strip.

In one or more embodiments of the method according to any one of the previous paragraphs, a thickness of the male terminal is greater than a thickness of the central portion of the strip.

In one or more embodiments of the method according to any one of the previous paragraphs, the strip may be bent by a force of less than 5 newtons.

In one or more embodiments of the method according to any one of the previous paragraphs, the male terminal extends beyond the width of the central portion of the strip.

In one or more embodiments of the method according to any one of the previous paragraphs, the thickness of the strip is in a range of 0.1 millimeters to 0.5 millimeters.

In one or more embodiments of the method according to any one of the previous paragraphs, the method further includes the step of folding a distal portion such that it defines two parallel tabs extending from the distal end.

The present invention will now be described, by way of example with reference to the accompanying drawings, in which:
Fig. 1 is a perspective top view of an electrical bus bar assembly with an integral blade-type male terminal according to some embodiments;
Fig. 2 is a perspective side view of the electrical bus bar assembly of Fig. 1 according to some embodiments;
Fig. 3A is a perspective view of an electrical bus bar assembly with an integral blade-type male terminal according to some embodiments;
Fig. 3B is a top view of the electrical bus bar assembly of Fig. 3A according to some embodiments;
Fig. 4A is a perspective side view of the integral blade-type male terminal of the electrical bus bar assembly of Fig. 3A according to some embodiments;
Fig. 4B is an enlarged side view of the integral blade-type male terminal of Fig. 4A according to some embodiments;
Fig. 5A is a perspective view an electrical connector assembly including the electrical bus bar assembly of Fig. 1 according to some embodiments;
Fig. 5B is a side view an electrical connector assembly including the electrical bus bar assembly of Fig. 1 according to some embodiments;
Fig. 5C is a top view an electrical connector assembly including the electrical bus bar assembly of Fig. 1 according to some embodiments;
Fig. 6A is perspective view of a weld pad terminal of an electrical bus bar assembly in an initial step of assembly according to some embodiments;
Fig. 6B is perspective view of a weld pad terminal of an electrical bus bar assembly in a subsequent step of assembly according to some embodiments;
Fig. 6C is perspective view of a weld pad terminal of an electrical bus bar assembly in final step of assembly according to some embodiments;
Fig. 7 is a perspective view of a terminal of an electrical bus bar assembly having parallel tabs according to some embodiments;
Fig. 8 is a top view of the terminal of Fig. 7 according to some embodiments;
Fig. 9A is a perspective view of the terminal of Fig. 7 with the parallel tabs attached to parallel sides of an electrical terminal according to some embodiments;
Fig. 9B is another perspective view of the terminal of Fig. 7 with the parallel tabs attached to parallel sides of an electrical terminal according to some embodiments;
Fig. 10 is a top view of a preform of the terminal of Fig. 7 according to some embodiments;
Fig. 11 is a perspective view of the preform of Fig. 10 according to some embodiments; and
Fig. 12 is a flow chart of a method of manufacturing an electrical bus bar assembly according to some embodiments.

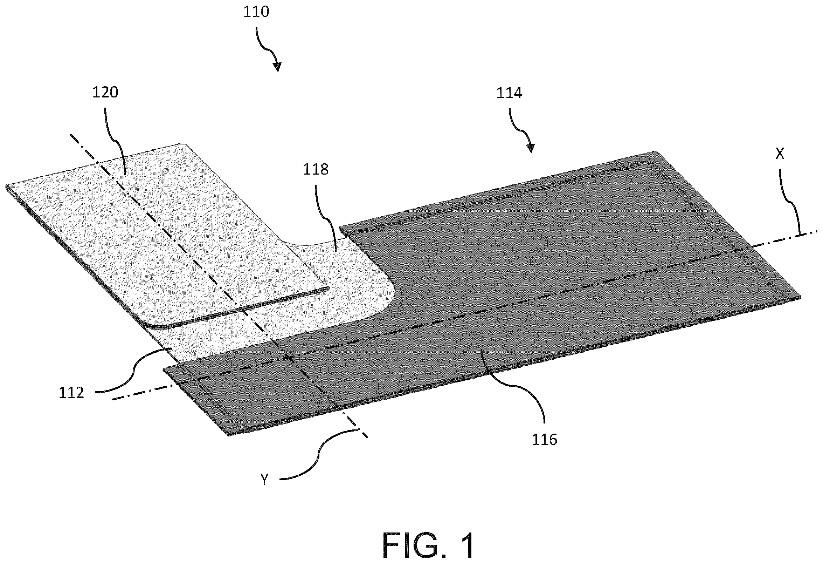

The electrical bus bar assembly, hereinafter referred to as the bus bar 110, shown in Fig. 1 is formed of a thin strip 112 of electrically conductive material, such as copper or aluminum. The strip 112 is flexible, meaning that it can be bent by its own weight or by a force of less than 5 newtons. The strip 112 has a generally rectangular cross section with a width to thickness ratio of at least 20:1. This width to thickness ratio may be higher, e.g., 60:1. The high width to thickness ratio of the strip 112 provides improved heat dissipation from the bus bar 110 compared to round wires or rigid bust bars. A central portion 114 of the strip 112 is covered or encased within a thin layer of an electrically insulative dielectric material 116, e.g., polyvinyl chloride, fluorinated ethylene propylene, tetrafluoroethylene, or polytetrafluoroethylene, leaving the ends 118 of the strip exposed. The dielectric material 116 is preferably also flexible. The strip 112 can be made from a wide single layer or a plurality of narrower layers. In some embodiments, the strip 112 has a width of 10 to 30 millimeters and a thickness of 0.1 to 0.5 millimeters.

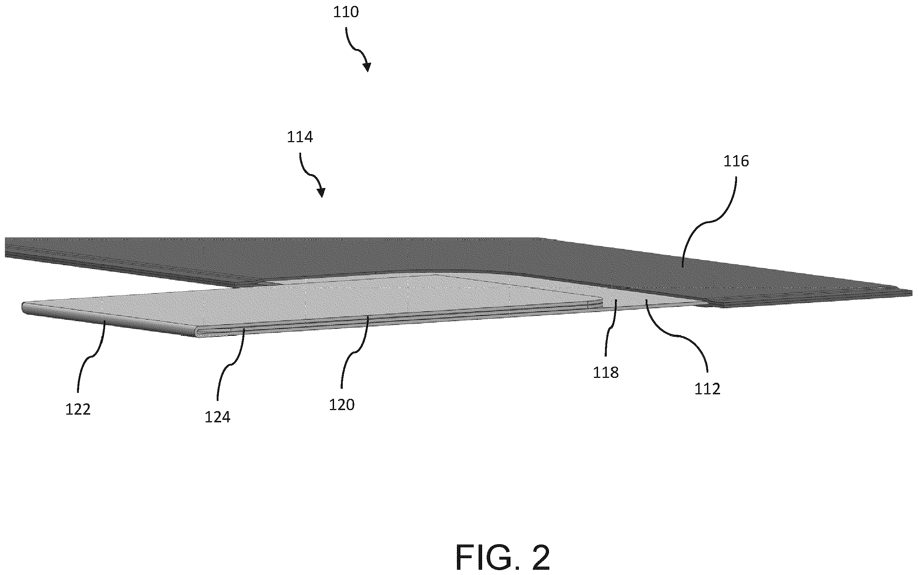

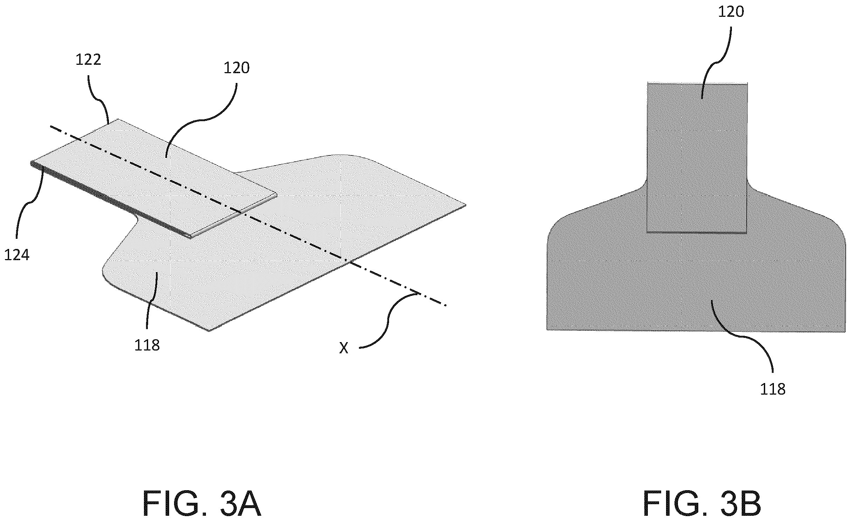

The exposed ends 118 of the strip 112 may be folded back onto themselves to integrally form a blade-type male terminal 120 that can be received within and make electrical connection with a female socket terminal (not shown). As shown in Fig. 2, the strip 112 is folded so that a leading edge 122 of the free end 124 of the male terminal 120 has a rounded shape that mimics the coined edge of a typical male blade terminal. As shown in Figs 1 and 2, the male terminal 120 may extend from the strip 112 along a lateral axis Y that is orthogonal to a longitudinal axis X of the strip 112. Alternatively, as shown in Figs. 3A-4B, the terminal 120 may extend from the strip 112 is a direction parallel with the longitudinal axis X of the strip 112.

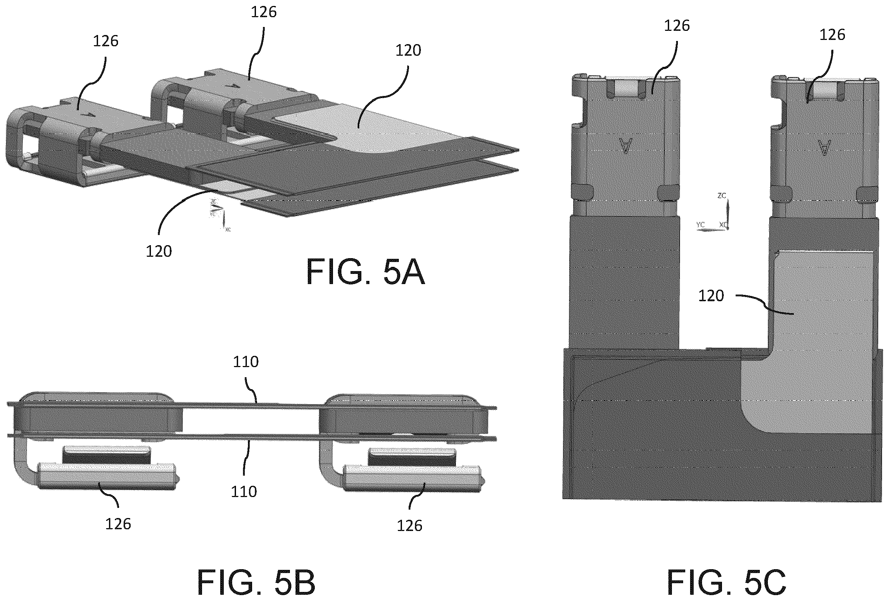

The male terminal 120 may instead be used as a weld pad to connect the bus bar 110 to a separate electrical terminal 126 using a welding process, such as resistance, sonic, or laser welding as shown in Figs. 5A, 5B, and 5C. The attached terminal 126 may be a simple male blade terminal or a multipiece female socket terminal. As illustrated in Figs. 5A, 5B, and 5C, multiple terminals 126 and bus bars 110 may be attached so that the bus bars 110 are arranged parallel to one another and the weld pads 120 may be connected to opposite side of the terminals 126 to provide a compact terminal/bus bar assembly. The thickness of the dielectric material 116 may be tuned to provide proper creepage protection between the bus bars 110. Alternatively, or in addition, clearance paths or insulative separators (not shown) may be installed between the bus bars 110.

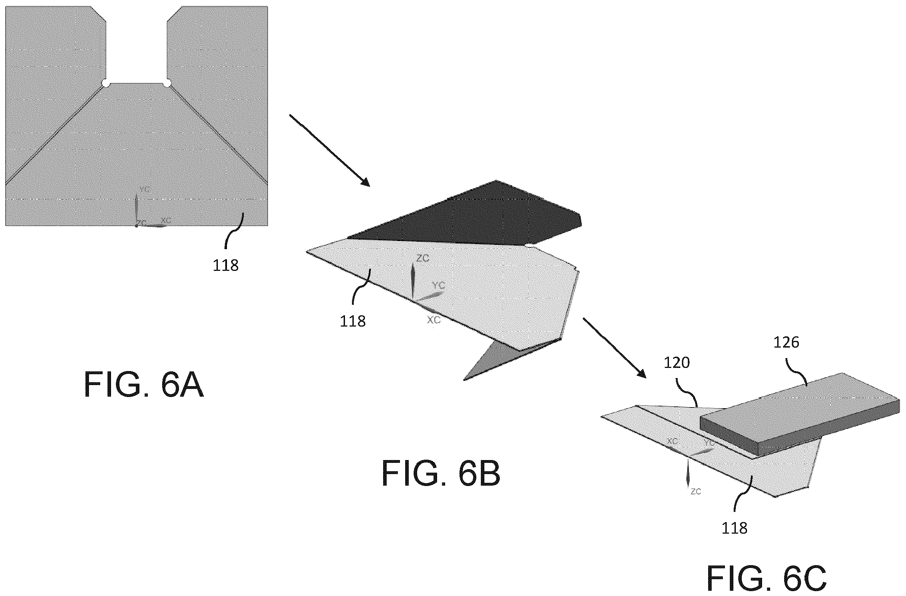

Figs. 6A, 6B, and 6C illustrate an alternative weld pad design 120 wherein the strip is folded so that the weld pad 120 had an increased thickness relative to the strip 112.

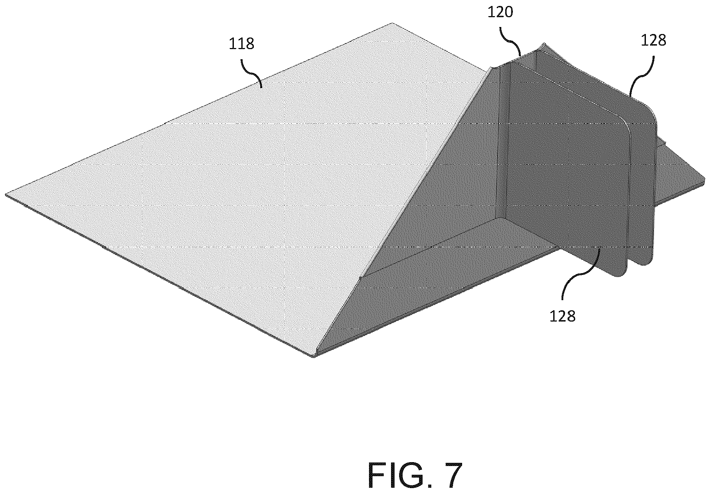

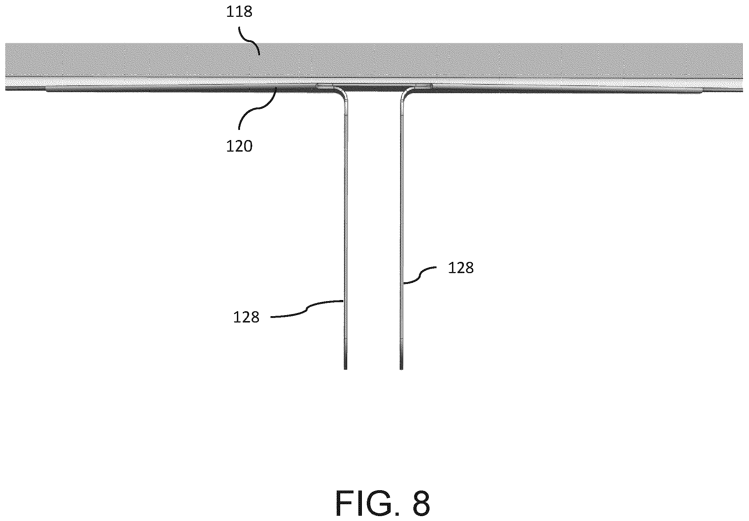

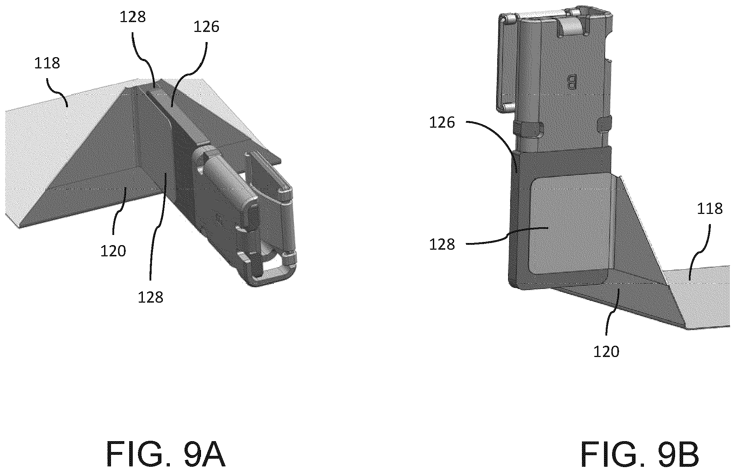

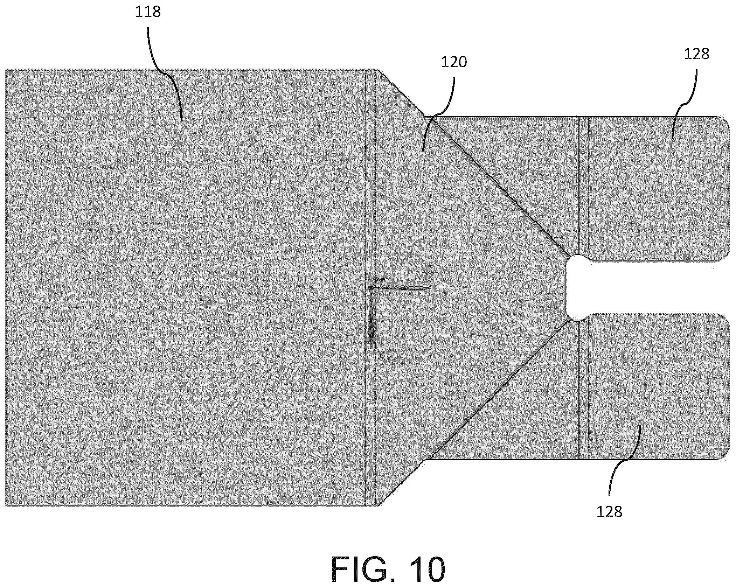

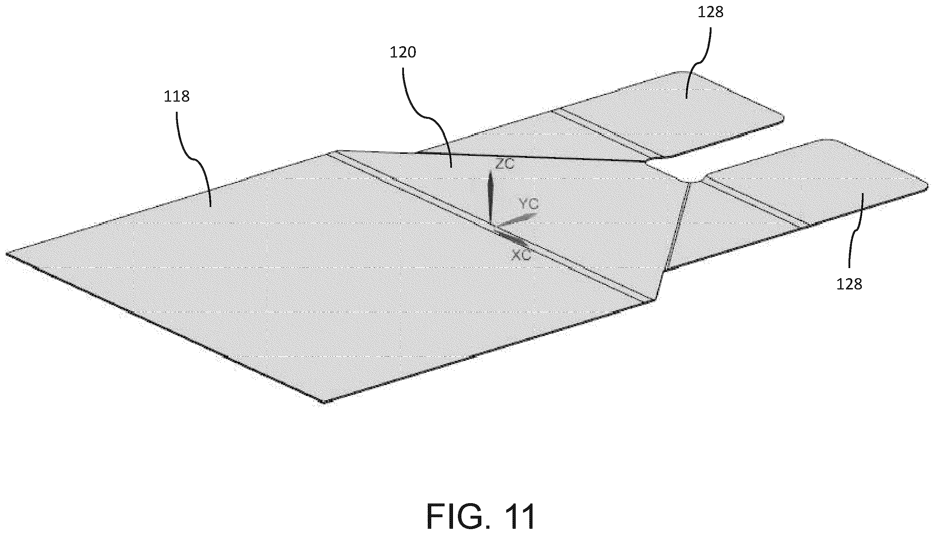

Figs. 7, 8, 9, 10, and 11 illustrate another alternative weld pad design 120 having two parallel tabs 128 that are welded to two parallel surfaces on an electrical terminal 126. The weld pad 120 is folded multiple times to provide this shape. This weld pad design allows for a gradual reduction of the cross section of the bus bar from the strip 112 to the terminal 126. This weld pad design may be used in an axial orientation as shown in Fig. 9A or in a right-angled configuration as shown in Fig. 9B.

The process of coating the strip 112 with the dielectric material 116 presents opportunities for improving termination and routing/bending with combined metal shapes within the bus bar.

Vertically stacking multiple bus bar assemblies is possible, and the bus bar can be specified to have parallel path conductors with a perforated section between them to aid folding and processed of a stacked configuration.

Perforations or holes may be made in the strip to aid in the folding and stamping of the terminal concepts described above. Similar holes or relief cuts can provide locations for connection system features such as primary locks, independent secondary locks, terminal position assurance devices, primary lock retainers, or strain relief features. Features can also be created in the strip to allow for terminal springs to be attached and provide contact normal force for an electrical connection.

Because there may be packaging limitations on how wide the bus bar can be for a given application, multiple bus bars may be stacked vertically. Stacking the bus bars vertically may cause cross-heating between the layers, thereby derating the current carrying capability. In order to address this cross-heating issue, a channel assembly may be incorporated into the bus bar assembly that will both provide benefits for routing and protection of the bus bar but may also be configured to act as a heat sink. Multiple materials have been considered, such as an extruded aluminum channel that can also provide electromagnetic shielding, a thermally conductive plastic channel, or a silicone paste, adhesive strip, or 2-shot epoxy/potting to provide a thermal conduction path. This channel can sink heat to the atmosphere, conduct heat to the vehicle body, or provide internal channels for a coolant fluid flow to pull heat away from the bus bar.

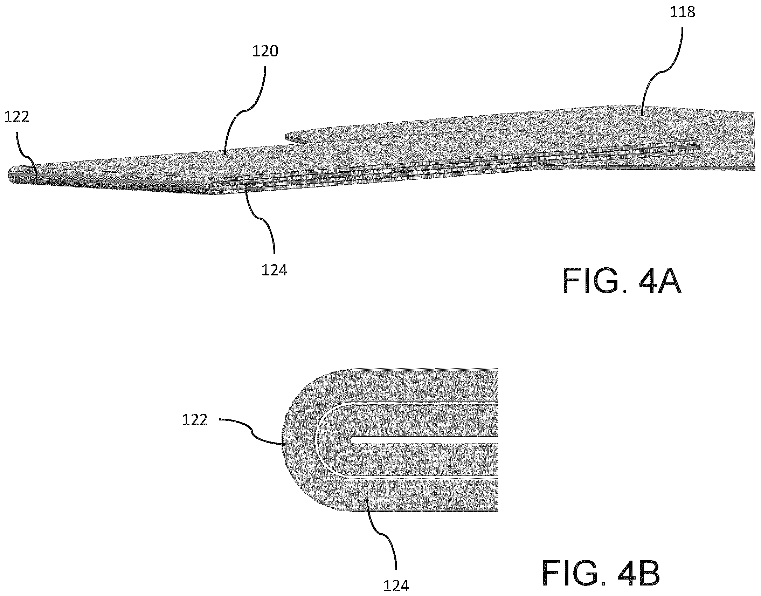

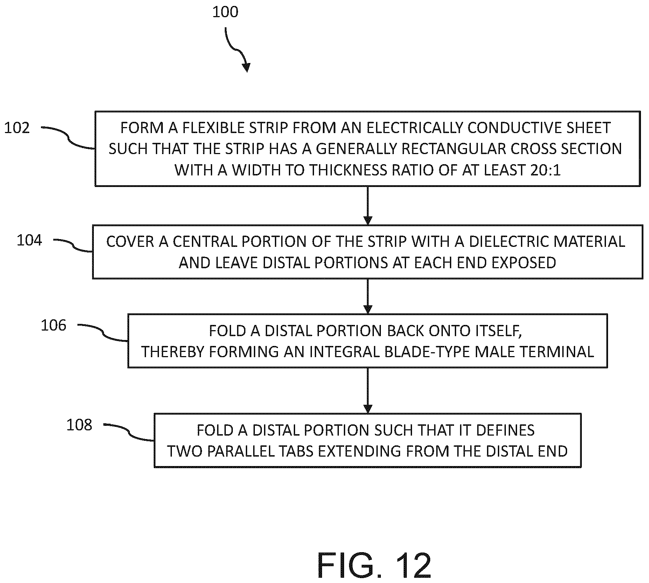

A method 100 of manufacturing an electrical bus bar assembly 110 is shown in the flow chart of Fig. 12. The various steps of the method 100 are outlined below:
STEP 102, FORM A FLEXIBLE STRIP FROM AN ELECTRICALLY CONDUCTIVE SHEET SUCH THAT THE STRIP HAS A GENERALLY RECTANGULAR CROSS SECTION WITH A WIDTH TO THICKNESS RATIO OF AT LEAST 20:1, includes forming a flexible strip 112 from an electrically conductive sheet such that the strip 112 has a generally rectangular cross section with a width to thickness ratio of at least 20:1;
STEP 104, COVER A CENTRAL PORTION OF THE STRIP WITH A DIELECTRIC MATERIAL AND LEAVE DISTAL PORTIONS AT EACH END EXPOSED, includes covering a central portion 114 of the strip 112 with a dielectric material 116 and leaving distal portions 118 at each end exposed;
STEP 106, FOLD A DISTAL PORTION BACK ONTO ITSELF, THEREBY FORMING AN INTEGRAL BLADE-TYPE MALE TERMINAL, includes folding a distal portion 118 back onto itself, thereby forming an integral blade-type male terminal 120 as shown in Figs. 3A, 3B, 4A, and 4B; and
STEP 108, FOLD A DISTAL PORTION SUCH THAT IT DEFINES TWO PARALLEL TABS EXTENDING FROM THE DISTAL END, includes folding a distal portion 118 such that it defines two parallel tabs 128 extending from the distal end 118.

Accordingly, a flexible bus bar assembly 110 suited for high power, i.e., high voltage/current applications, and a method 100 for manufacturing such a bus bar assembly is provided. The bus bar assembly 110 and the method 100 provide the benefit of a flexible electrical circuit conductor that can be easily routed, e.g., in an automobile wiring system. The bus bar assembly 110 and the method 100 also provide the benefit of better heat dissipation than traditional round wires or rigid bus bars.

While the invention has been described with reference to an exemplary embodiment(s), it will be understood by those skilled in the art that various changes may be made, and equivalents may be substituted for elements thereof without departing from the scope of the invention. In addition, many modifications may be made to adapt a particular situation or material to the teachings of the invention without departing from the essential scope thereof. Therefore, it is intended that the invention is not limited to the disclosed embodiment(s), but that the invention will include all embodiments falling within the scope of the appended claims.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of ordinance or orientation may be used herein these elements should not be limited by these terms. All terms of ordinance or orientation, unless stated otherwise, are used for purposes distinguishing one element from another, and do not denote any particular order, order of operations, direction or orientation unless stated otherwise.

## Claims

1. An electrical bus bar assembly (110), comprising:
an elongate flexible electrical conductor (112) formed of a strip of electrically conductive material having a generally rectangular cross section and a width to thickness ratio of at least 20:1; and
a dielectric material (116) covering a central portion (114) of the electrical conductor (112) such that the electrical conductor (112) has exposed distal portions (118) at each end of the assembly.

2. The electrical bus bar assembly (110) according to claim 1, wherein one of the exposed portions (118) is folded back onto itself to form an integral blade-type male terminal (120).

3. The electrical bus bar assembly (110) according to claim 2, wherein the male terminal (120) is formed of at least two layers of the electrically conductive material.

4. The electrical bus bar assembly (110) according to claim 2, wherein a leading edge (122) of a free end (124) of the male terminal (120) has a rounded edge.

5. The electrical bus bar assembly (110) according to claim 2, wherein a width of the male terminal (120) is less than a width of the electrical conductor (112) covered by the dielectric material (116).

6. The electrical bus bar assembly (110) according to claim 5, wherein a thickness of the male terminal (120) is greater than a thickness of the central portion (114) of the electrical conductor (112).

7. The electrical bus bar assembly (110) according to claim 2, wherein the flexible electrical conductor (112) may be bent by a force of less than 5 newtons.

8. The electrical bus bar assembly (110) according to claim 2, wherein the male terminal (120) extends beyond the width of the central portion (114) of the electrical conductor (112) .

9. The electrical bus bar assembly (110) according to claim 1, wherein the thickness of the electrical conductor (112) is in a range of 0.1 millimeters to 0.5 millimeters.

10. The electrical bus bar assembly (110) according to claim 1, wherein one of the exposed distal portions (118) defines two parallel tabs (128) extending from the bus bar assembly (110) and wherein the two tabs (128) are configured to be welded to two different parallel sides of an electrical terminal (126).

11. A method (100) of manufacturing an electrical bus bar assembly (110), comprising:
forming (102) a flexible strip (112) from an electrically conductive sheet such that the strip (112) has a generally rectangular cross section with a width to thickness ratio of at least 20:1; and
covering (104) a central portion (114) of the strip (112) with a dielectric material (116) and leaving distal portions (118) at each end exposed.

12. The method (100) according to claim 11, further comprising folding (106) the distal portion (118) back onto itself, thereby forming an integral blade-type male terminal (120) formed of at least two layers of the strip (112).

13. The method (100) according to claim 12, wherein a width of the male terminal (120) is less than a width of the strip (112).

14. The method (100) according to claim 15, wherein a thickness of the male terminal (120) is greater than a thickness of the central portion (114) of the strip (112).

15. The method (100) according to claim 11, further comprising folding the distal portion (118) such that it defines two parallel tabs (128) extending from the distal end (118).
